# EUROPEAN PATENT APPLICATION

(11) **EP 2 398 046 A1**
(43) Date of publication of application: **21.12.2011**
(21) Application number: 10166436.5
(22) Date of filing: 18.06.2010
(51) Int. Cl.: H01L 21/60, H01L 23/482

(54) **Integrated circuit package with a copper-tin joining layer and manufacturing method thereof**

(71) Applicant: NXP B.V., 5656 AG Eindhoven (NL)
(72) Inventor: Rother, Michael, 5656 AG Eindhoven (NL)
(74) Representative: Williamson, Paul Lewis

(57) **Abstract**

Circuit components (110,160) are joined using a copper-tin (Cu-Sn) alloy. A barrier layer/adhesion promoter (120) is sputtered on a bond connection surface (112) of a package component (110), a seed layer of copper (130) is applied thereon and a copper layer (140) is plated on the seed layer (130). The copper layer (140) is put in contact with a tin layer (150) by positioning a package component (160), having a layer of tin (150) thereon. The copper and tin layers (140,150) are heated to form a Cu-Sn alloy, melt the Cu-Sn alloy and react substantially all of the tin to form a Cu-Sn intermetallic compound (170) from the alloy, physically and electrically coupling components (110,160) together. Component (110) may be a semiconductor or integrated circuit substrate. Component (160) may be a leadframe or a circuit board. The barrier layer/adhesion promoter (120), the Cu seed layer (130) and the plated Cu layer (140) may be patterned. The tin layer (140) may alternatively be formed directly on the plated Cu layer (130).

## Description

### BACKGROUND

Integrated circuits are often fabricated on chips that are connected to a larger package via bond pads and/or other types of electrical connectors, using a connective joining material such as solder. These packages may include multiple circuits and devices, and can be incorporated into larger circuits (e.g., onto a printed circuit board). The packaging process may involve integrating many circuit dies upon a particular package, with connections between each die and the package.

Many integrated circuit components and related manufacturing processes have been challenging to implement due to issues with materials and processes used in making electrical connections. For example, lead and lead-based materials have been used in solder connectors, but pose environmental challenges on many fronts. In addition, many soldering approaches are susceptible to undesirable characteristics, such as solder voiding, solder splash, flux contamination, misalignment, solder dedicated re-melting temperatures, or peeling, which can be detrimental to device integration and performance.

These and other matters have presented challenges to connecting integrated circuits, and related device operation.

### SUMMARY

Various example embodiments are directed to circuit connectors and approaches to connecting circuits, such as for connecting integrated circuit chips with leadframes using a bond pad.

In accordance with an example embodiment, an integrated circuit device is manufactured as follows. A metal barrier layer/adhesion promoter is sputtered on a bond connection surface (e.g., a redistribution layer), and a seed layer of copper is applied on the barrier layer/adhesion promoter. Copper is plated on the seed layer to form a plated copper layer. A layer of tin is introduced to the plated copper layer, such as by positioning a circuit component having the layer of tin thereupon, such that the tin layer contacts the plated copper layer. In some implementations, the seed layer and barrier layer/adhesion promoter are patterned to form a bond pad pattern, and copper is galvanically plated on the patterned seed layer to form a patterned metal stack having a pattern that matches the patterned seed layer. The copper and tin is heated to form a Cu-Sn alloy, melt the Cu-Sn alloy, and react substantially all of the tin to form a Cu-Sn intermetallic compound from the alloy. The compound physically and electrically connects the connection surface with another connector (e.g., a copper connector).

Another example embodiment is directed to a method for joining a semiconductor substrate with a leadframe having tin connectors. A barrier layer/adhesion promoter is sputtered on a surface of the substrate, and a seed layer of copper is sputtered on the barrier layer/adhesion promoter. The seed layer and barrier layer/adhesion promoter are patterned to form a bond pad pattern, and copper is galvanically plated on the patterned seed layer to form a patterned copper layer having a pattern that matches the patterned seed layer. The leadframe (e.g., a copper lead frame that is galvanically tin plated) is positioned to contact the patterned copper layer. The copper and tin are heated to form a Cu-Sn alloy, melt the alloy, and react substantially all of the tin to form a Cu-Sn intermetallic compound that physically and electrically connects the substrate surface with the leadframe.

In connection with another example embodiment, an integrated circuit package includes an integrated circuit substrate and a leadframe. The substrate includes a bond connection surface, and a sputtered barrier layer/adhesion promoter is located on the connection surface. A seed layer of copper is on the barrier layer/adhesion promoter, and plated copper is on the seed layer. The leadframe has a layer of tin for bonding with the integrated circuit substrate via the plated copper. The tin layer is configured via its thickness to, upon contact with the copper and heating of the copper and tin, form a Cu-Sn alloy that melts, and to form a Cu-Sn intermetallic compound from the alloy via reaction of substantially all of the tin. The compound physically and electrically connecting the connection surface with the leadframe.

The above discussion/summary is not intended to describe each embodiment or every implementation of the present disclosure. The figures and detailed description that follow also exemplify various embodiments.

### FIGURES

Various example embodiments may be more completely understood in consideration of the following detailed description in connection with the accompanying drawings, in which:
FIG. 1 shows a cross-sectional view of a bond package at various stages of manufacture, in accordance with one or more example embodiments of the present invention;
FIG. 2 is a flow diagram for a method for manufacturing a low-lead or leadless bond package, according to another example embodiment of the present invention;
FIG. 3 shows a phase diagram of a copper-tin (Cu-Sn) material as used in accordance with one or more example embodiments of the present invention; and
FIG. 4 shows temperature versus copper content for a joining material, in accordance with other example embodiments of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention including aspects defined in the claims.

### DETAILED DESCRIPTION

The present invention is believed to be applicable to a variety of different types of processes, devices and arrangements for use with various circuits, including integrated circuits coupled into package arrangements using a joining material and related processes. While the present invention is not necessarily so limited, various aspects of the invention may be appreciated through a discussion of examples using this context.

According to an example embodiment, a copper and tin-based joining material is used to connect circuits in an integrated circuit device. A copper and tin alloy is formed over a surface, heated (melted) and reacted to form a copper-tin (Cu-Sn) intermetallic compound, in which substantially all of the tin is reacted in forming the compound. The Cu-Sn intermetallic compound includes a material such as Cu₆Sn₅ that both physically and electrically couples the surface and another circuit component. This approach can be carried out, and the resulting structure can be made, in a lead-free manner addressing various challenges including those discussed in the background above.

The respective thicknesses of the copper and/or tin, as well as other adjacent materials and processing conditions relating to heating are selected to suit various applications and facilitate the reaction of substantially all of the tin. In various applications, reacting substantially all of the tin involves reacting at least 80% of the tin, at least 90% of the tin, at least 95% of the tin or at least 98% of the tin. In addition, various embodiments involving the formation of a Cu-Sn compound involve doing so in a lead-free or substantially lead-free environment.

In some implementations, the respective thicknesses of the copper and/or tin are set to achieve a selected (low) melting point temperature of the alloy, and a correspondingly higher melting point temperature of the resulting intermetallic compound. The copper and tin alloy is heated to melt/flow the alloy at the desirably low temperature (e.g., around 230 °C), to form the intermetallic compound and join circuit components. As the resulting intermetallic compound is formed, it solidifies and exhibits a relatively higher melting temperature (e.g., at or above about 400 °C).

According to a more particular example embodiment, a barrier layer/adhesion promoter is used as an interface between the copper and tin alloy and the surface over which the alloy is formed. The barrier layer/adhesion promoter may operate to effect one or both of barrier and adhesion properties and may include, for example, titanium-based material, a nickel-based material an, or a vanadium-based material. The barrier layer/adhesion promoter can be sputtered upon the surface underlying the copper/tin alloy before the formation thereof. In many implementations, the barrier layer/adhesion promoter has barrier properties that mitigate the formation of additional intermetallic compound (in later processing) at a particular temperature.

The copper and corresponding copper/tin alloy can be formed using a variety of approaches. In one embodiment, a seed layer of copper is applied first and functions as a landing place for subsequently-formed copper (e.g., via galvanic plating), followed by plating of a copper layer on the seed layer to form a plated copper layer. Where a barrier layer/adhesion promoter is used as discussed above, the seed layer of copper is applied to the barrier layer/adhesion promoter, with the combined adhesion-layer material and copper seed layer forming a combined material that facilitates the subsequent plating of the copper layer, from an adhesion and formation perspective. Once the plated copper layer is formed, tin (e.g., a layer) is contacted with the plated copper layer to form a copper-tin (Cu-Sn) alloy.

The tin (layer) is introduced to and contacts the plated copper in a variety of manners. In one implementation, a tin layer of a selected thickness is formed on an integrated circuit package component, such as a leadframe, to be joined to a chip on which the plated copper is formed. The integrated circuit package component is then positioned to contact the tin layer with the plated copper. In another implementation, a tin layer is formed directly on the plated copper layer. In these (or other) implementations, the thickness of the tin layer can be set thin enough such that all of the tin is consumed in a subsequent reaction to form an intermetallic compound, as discussed further below.

Upon heating, the copper and tin in the Cu-Sn alloy melt and the copper and tin in the melted alloy react to form a copper-tin (Cu-Sn) intermetallic compound. During the reaction, all or substantially all of the tin reacts. This compound physically (e.g., mechanically) and electrically couples the underlying surface with the resulting (overlying) circuit. This approach is applicable to joining a bond package arrangement in which a package component such as a silicon chip is joined to another package component such as a leadframe.

In some embodiments, upper and lower surfaces of an integrated circuit chip are coated with a barrier layer/adhesion promoter and copper seed layer, and subsequently plated with copper as described herein. Additional package components are subsequently connected to each side of the chip, using a tin layer as discussed to form a copper-tin alloy and, therefrom, a copper-tin intermetallic compound via consumption of the tin.

In connection with various example embodiments, it has been discovered that the respective thicknesses of layers including one or more of respective copper and tin materials, adhesion material and seed material can be set together with the temperature and time at which the Cu-Sn alloy is heated to effect the reaction of substantially all of the Sn to form the Cu-Sn intermetallic compound. The respective layers are formed to the set thicknesses, and the materials are subjected to heating at the set temperature for the selected time, to form the Cu-Sn intermetallic compound.

In some embodiments, respective layer thicknesses as discussed above include a 0.2µm layer of Titanium adhesion material, a 0.2µm seed layer of copper, a 5µm plated copper layer and a 3µm layer of tin. The thickness of the tin layer is varied, in connection with different embodiments, to ensure the consumption of the tin in forming a Cu-Sn compound with the underlying copper.

The package components that the Cu-Sn alloy is used to connect may vary depending upon the application. For example, the alloy (and subsequent compound) can be formed on an underlying surface of a circuit board or other package component, with another package component such as a leadframe added above and coupled with the underlying surface via heating and reaction to form the Cu-Sn compound. For instance, bond pads of respective circuits on different package components can be connected to one another using this approach. In addition, the alloy (and subsequent compound) can also be formed upon the underside of a device such as a circuit or package component, to be coupled to an underlying circuit board (or other package component).

As consistent with the examples discussed herein, various embodiments are directed to integrated circuits, circuit packages, circuit boards and related devices employing a copper-tin based joining material as described. Other embodiments are directed to methods for manufacturing such circuits, packages, boards and devices using the copper-tin based joining material.

Still other embodiments are directed to devices at an intermediate stage of manufacture. For example, one such embodiment is directed to an intermediate device having a copper/tin alloy material, together with one or more related materials and material layers as described (e.g., adhesion and/or seed layers). The intermediate device and the respective layers are configured for subsequent heating, at an appropriate stage of further manufacture, when the device is joined to another package component. Other examples involve devices at other stages of manufacture, such as a device amenable to the addition of tin to a plated copper layer that has been prepared for further processing. For instance, such embodiments may involve one or both components of a two-component package (e.g., chip and leadframe) that is yet to be joined, with one component having a plated copper layer and the other component having a tin layer, as discussed. Various embodiments are also directed to methods for manufacturing such devices.

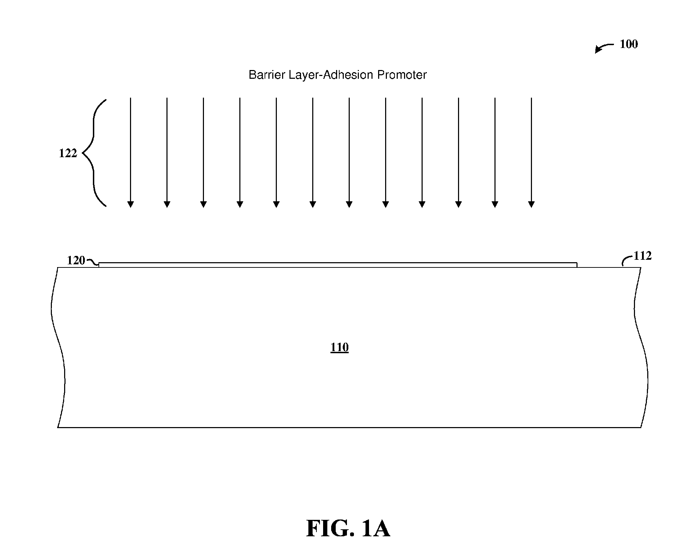

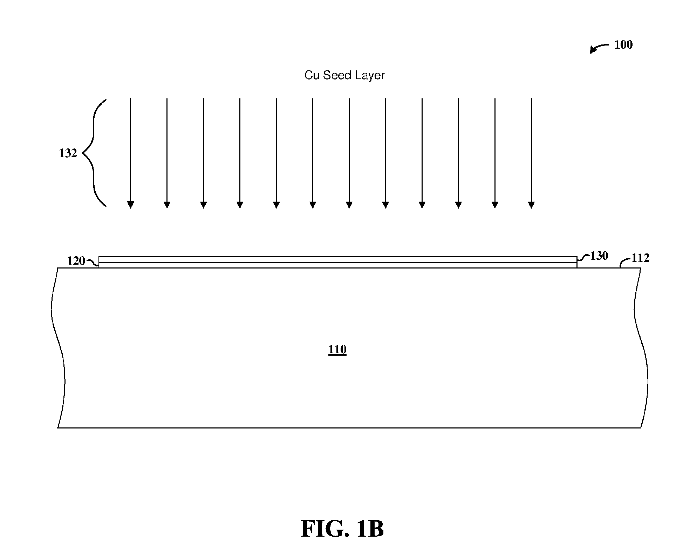

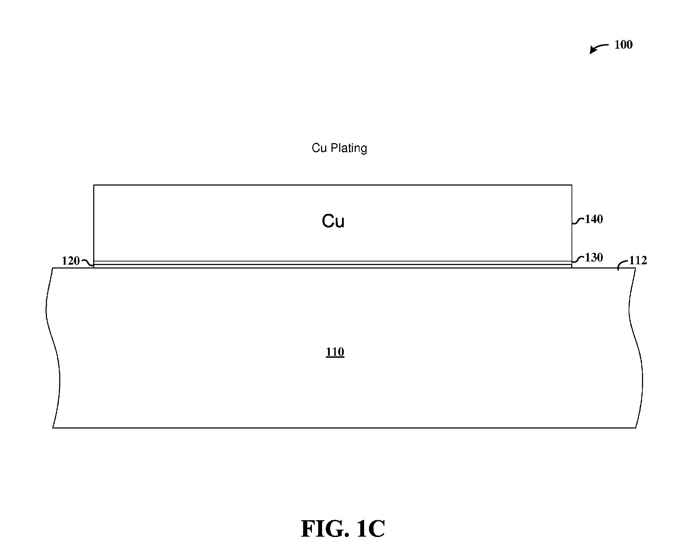

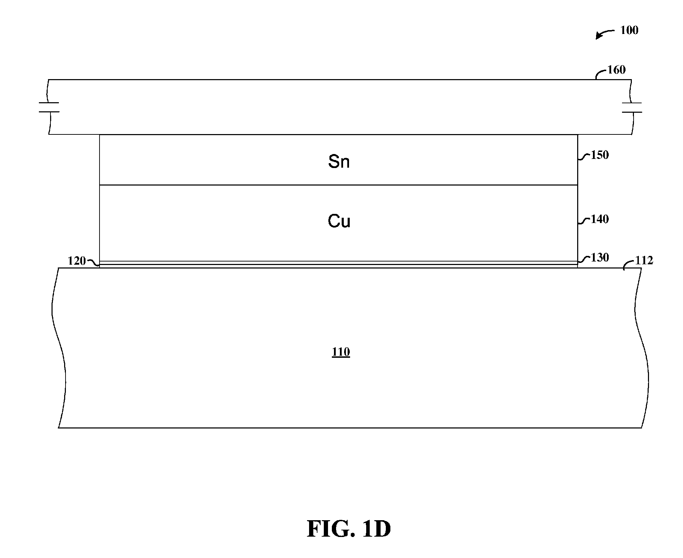

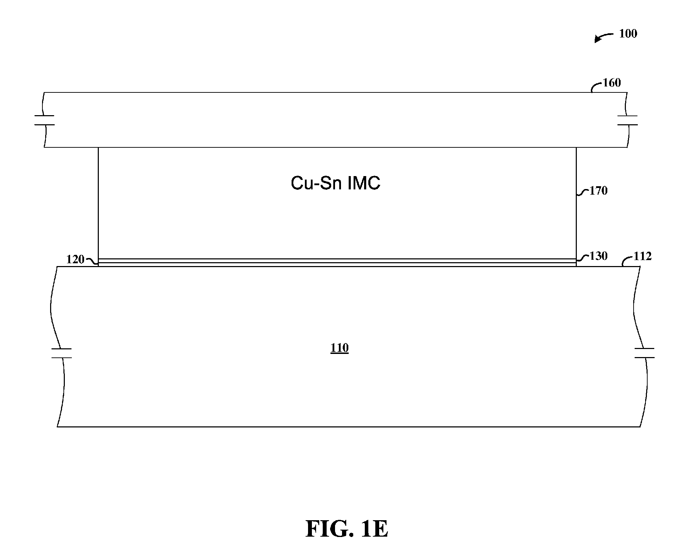

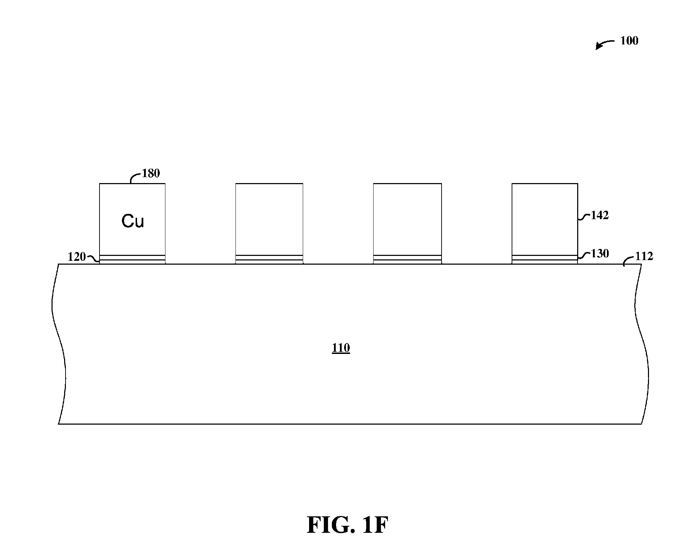

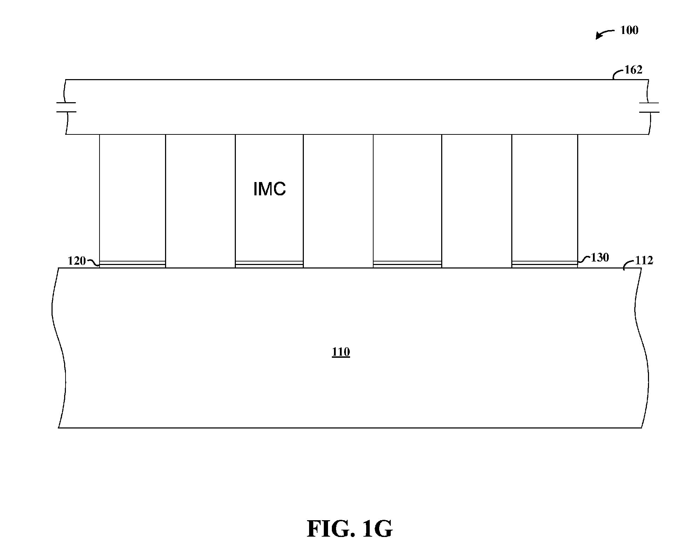

Turning now to the Figures, Figure 1 shows a bond package 100 at various stages of manufacture, in accordance with one or more example embodiments of the present invention. Each of the various stages represent different embodiments, such as may pertain to a device at different stages of manufacture and the corresponding manufacturing steps to get to the respective stages. In addition, the respective stages may be implemented together as part of a manufacturing process in accordance with a more particular embodiment. Moreover, other embodiments involve later stages of manufacture, in which a package is provided at an intermediate stage of manufacture and further manufacturing steps are carried out. Still other embodiments are directed to the implementation of intermediate stages of manufacture, where a package is received at an earlier stage of processing and provided at a later stage of processing but prior to completion.

Beginning with Figure 1A, a package component 110 is/has been treated at its surface 112 with a barrier layer/adhesion promoter 120, which may be applied via sputtering (represented by arrows 122). The barrier layer/adhesion promoter layer 120 includes one or more of a variety of materials that facilitate the adhesion of the surface and act as a diffusion barrier to surface 112 with an overlying copper-tin layer component (e.g., with a copper layer formed upon the adhesion promoter layer).

In Figure 1B, a copper seed layer 130 is shown formed on a barrier layer/adhesion promoter 120, which may also be applied via sputtering as represented with arrows 132. The seed layer 130 may be formed using a liquid-liquid-solid formation approach relating to different liquid and solid phases of the copper in the seed layer. The respective thicknesses of the barrier layer / adhesion promoter 120 and the seed layer 132 are selected to suit the particular application. In some implementations, the thicknesses are about equal, and in a more particular implementation, the thicknesses are about 0.2 µm. In some embodiments, the copper seed layer 130 is patterned, as shown in Figure 1F and described further below.

In Figure 1C, a copper (Cu) layer 140 has been plated on underlying adhesion and copper seed layers 120 and 130. The adhesion layer facilitates adhesion of the copper seed layer, which may effectively become part of the resulting copper layer 140 (as would include the seed layer 130). In this context, the copper layer 140 may be adhered directly to the surface 112 of the underlying package component 110. The thickness of the copper layer 140 varies with implementations, and in some embodiments, is around 5 µm.

In Figure 1D, a tin (Sn) layer 150 has been formed (e.g., plated) on an upper package component 160, such as a leadframe, which is positioned to contact the tin layer with the copper layer 140. As with the package component 110, the upper package component 160 is represented in cross-section with the further understanding that the height and width of the package may vary (relatively) in different applications. The resulting copper and tin layers 140 and 150 form (e.g., upon heating) a Cu-Sn alloy, which may also include seed layer 130 as discussed above. The thickness of the tin layer 150 varies with different applications, such as to ensure consumption of the tin via combination with the copper in copper layer 140. In some embodiments, the tin layer 150's thickness is around 3 µm. The resulting alloy has a melting point that is desirably low, and in some implementations, around 230°C.

In Figure 1E, the Cu-Sn alloy has been heated to its melting point and reacted to form a copper-tin (Cu-Sn) compound 170. The resulting compound 170 mechanically and electrically couples the upper package component 160 to the surface 112 of the underlying package component 110. The Cu-Sn compound 170 (*e.g.,* an intermetallic compound) has a desirably high melting point. In some embodiments, the Cu-Sn compound 170 has a melting point that is substantially higher than the melting point of the Cu-Sn alloy. In some contexts, the substantially higher melting point is a melting point that is above about 300°C, and in other contexts, the substantially higher melting point is above about 400°C.

The package components 110 and 160 may include one or more of a variety of components, such as individual bond pad contacts or devices having an array of such contacts. For example, various embodiments involve manufacturing a bond-pad sized Cu-Sn compound 170, having dimensions that fit the particular application. Other embodiments are directed to the formation of several bond pad connections. These applications are particularly amenable to small-dimension packages, and can be effected without solder prints.

As an example of bond pad arrangements, Figure 1F shows a bond package 100 patterned to suit a particular connectivity pattern of respective package components, before reaction of the Cu-Sn alloy to form a Cu-Sn IMC (e.g., similar to the stage shown in Figure 1D). A plurality of individual bond pad stacks are formed as shown, with stack 180 labeled by way of example. One approach to forming the stacks involves patterning the plated copper layer 130 (and, in some instances, the underlying adhesion layer 120 as well), prior to plating a copper layer 142. With this approach, the plated copper 142 is formed on the remaining (patterned) seed layer portions and does not have to be patterned.

Figure 1G shows the patterned Cu-Sn alloy as reacted to form a Cu-Sn IMC material for coupling an upper package component 162. As consistent with the embodiment shown in Figure 1D, the upper package component 162 may be introduced with a tin layer patterned to match the pattern of plated copper as shown, which reacts to form a Cu-Sn alloy and, further, a Cu-Sn intermetallic compound that joins the package components 110 and 162.

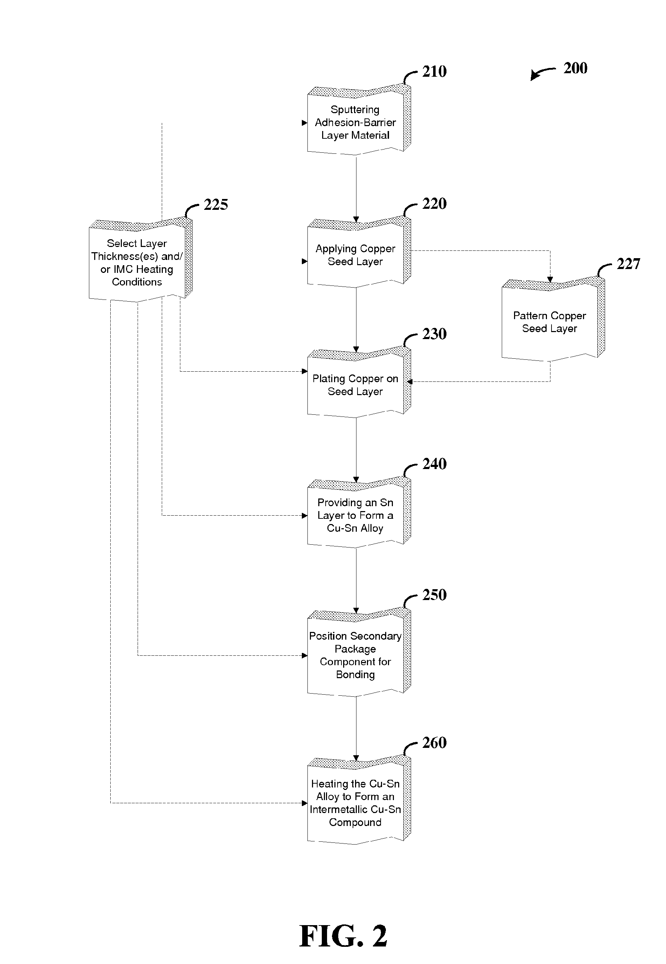

FIG. 2 is a flow diagram for a method for manufacturing a low-lead or leadless bond package, according to another example embodiment of the present invention. At block 210, an adhesion material is sputtered onto a surface of a package substrate, and a copper (Cu) seed layer is applied to the adhesion material at block 220. Using the copper seed layer, copper is plated onto the seed layer at block 230.

At block 240, a tin (Sn) layer is provided on the plated copper layer formed at block 230, to form a copper-tin (Cu-Sn) alloy. A secondary package component is positioned for bonding at block 250, such as by bringing one or more bonding pads into contact with the Cu-Sn alloy. In many applications, the secondary package component (e.g., a leadframe) has the layer of Sn, which is contacted to the plated copper layer formed at block 230. At block 260, the Cu-Sn alloy is heated to form a Cu-Sn intermetallic compound (IMC) such as Cu₆Sn₅. After solidification, the Cu-Sn IMC exhibits a higher melting point than the Cu-Sn alloy, which facilitates further high-temperature processing. In some implementations, a flux is applied (e.g., sprayed) to mitigate the oxidation or other degradation of the materials as the Cu-Sn intermetallic compound is formed, and removed as appropriate after formation of the IMC.

The positioning of the secondary package component at block 250 may also be carried out in connection with the heating at block 260. For example, the Cu-Sn alloy may be heated to melt the alloy, with the secondary package component brought into contact with the alloy before it cools and solidifies.

In some embodiments, the thickness of one or both of the respective copper and tin layers, and sometimes of the adhesion and seed layers as well, are selected together with IMC heating conditions at block 225 to facilitate consumption of the Sn layer provided at block 240 in forming the Cu-Sn IMC at block 260. For instance, as discussed in connection with the above discovery-type embodiments, the respective thicknesses can be so chosen along with temperature and time parameters of the heating in the IMC formation at block 260 to ensure the consumption of the Sn layer. Such thicknesses and temperatures may include those as discussed herein, such as by heating a 2-4µm layer of tin to a temperature of about 230°C for several minutes, an hour or more. As would be understood, the respective thicknesses, temperature and time can be set to suit various applications and facilitate the use of these approaches with different types of equipment. As appropriate, the thickness selection steps at block 225 may be carried out prior to and/or in connection with any of the steps as shown, such as in connection with one or both of the application of the copper seed layer at block 220 and the sputtering of adhesion material at block 210. Dashed lines connecting block 225 to the other blocks represent these exemplary processes, in which thickness and heating conditions are selected for one or more steps as shown.

In certain embodiments, the copper seed layer is patterned at block 227, prior to plating the copper layer at block 230. In some implementations, the adhesion material is also patterned at block 227. This patterning facilitates the formation of the plated copper at block 230 in a predefined pattern as applied to the copper layer.

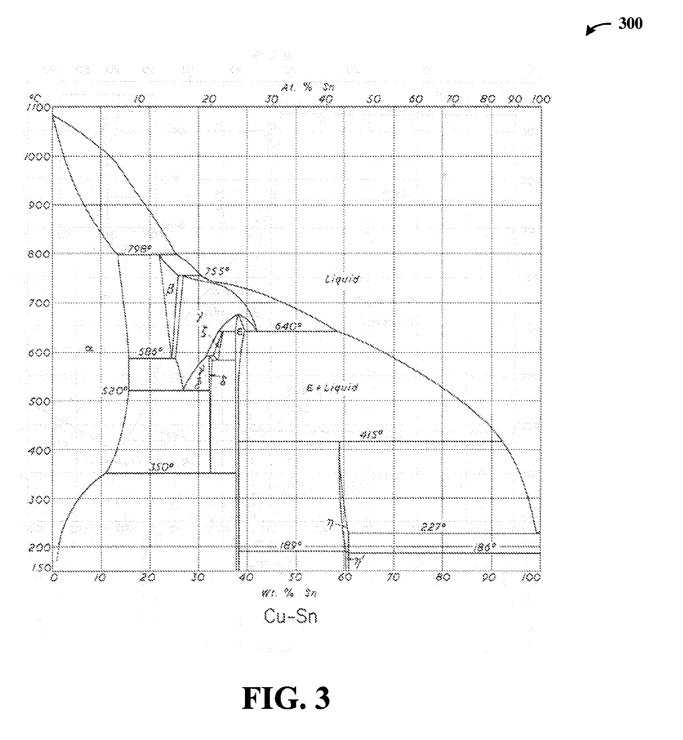

FIG. 3 shows a phase diagram 300 of a copper-tin (Cu-Sn) material as representing materials used in accordance with one or more example embodiments of the present invention. Based upon this phase diagram, a copper-tin compound can be formed from a copper-tin alloy via melting of the alloy and combination of the melted alloy components to form a (solidified) compound having a resulting higher melting temperature. As can be seen near the right-most portion of the phase diagram, the Cu-Sn alloy melts at temperatures approaching and just beyond 200°C. Referring to Figure 1, this approach is relevant to melting an alloy formed via tin layer 150 and at least a portion of copper layer 140 as shown in Figure 1D, as combined prior to melting to form the IMC 170 in Figure 1E. When the tin is reacted with copper, the melting point of the resulting compound is much higher, as the composition of copper increases in the compound. For Cu₆Sn₅ at a copper percentage of about 55%, the resulting melting temperature is above 400°C.

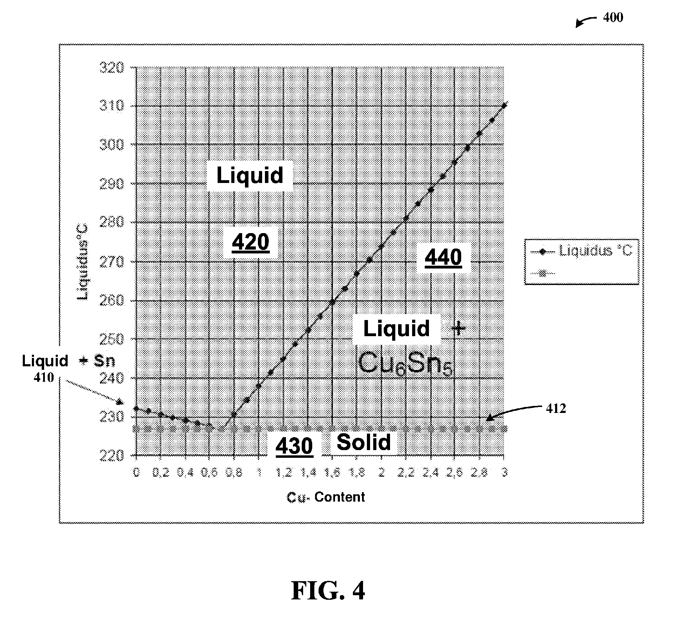

FIG. 4 shows a plot 400 of temperature versus copper content for a joining material, in accordance with other example embodiments of the present invention. As consistent with the above discussion in Figure 3, the plot 400 shows a liquid phase above plot 410 at region 420. A solid phase is below plot 412 at region 430, and a liquid + Cu-Sn IMC (Cu₆Sn₅) phase is between plots 410 and 412 at region 430.

The plot 410 represents a line of temperature below which a Cu-Sn alloy is in solid form, and above which melting occurs. Held above the melting temperature for a significant amount of time (and at a sufficiently thin layer of tin), substantially all of the tin reacts with the copper to form a Cu-Sn compound as described. As the Cu-Sn is initially heated, liquid CuSn is formed as shown in liquid region 420. As more of the copper and tin reacts to form a Cu-Sn IMC (Cu₆Sn₅), a combination of liquid + Cu₆Sn₅ is present and, as the tin is consumed, becomes all Cu₆Sn₅ (solidified).

Based upon the above discussion and illustrations, those skilled in the art will readily recognize that various modifications and changes may be made to the present invention without strictly following the exemplary embodiments and applications illustrated and described herein. For example, the content of the copper/tin (Cu-Sn) materials as shown may be varied depending upon the application, as may be the relative thickness and placement as shown in and/or described in connection with the figures, or otherwise. In addition, the phase of the resulting intermetallic compound of Cu-Sn material may vary, depending upon the application. Such modifications do not depart from the true spirit and scope of the present invention, including that set forth in the following claims.

## Claims

1. A method for manufacturing an integrated circuit device, the method comprising:
sputtering a barrier layer-adhesion promoter on a bond connection surface;
applying a seed layer of Cu on the barrier layer-adhesion promoter;
plating Cu on the seed layer to form a plated Cu layer;
introducing a layer of Sn to the plated Cu layer;
heating the Cu and Sn to form a Cu-Sn alloy, melt the Cu-Sn alloy, and react substantially all of the Sn to form a Cu-Sn intermetallic compound from the alloy, the Cu-Sn intermetallic compound physically and electrically connecting the connection surface with another connector via.

2. The method of claim 1,
further including selecting the thickness of the Sn layer and both the temperature and time at which to heat the device to effect the reaction of substantially all of the Sn to form the Cu-Sn intermetallic compound,
providing a layer of Sn includes forming the layer to the selected thicknesses, wherein heating includes heating the Cu-Sn alloy to the selected temperature for the selected time.

3. The method of claim 1,
further including patterning the seed layer of Cu, prior to plating Cu, and
herein plating Cu on the seed layer introducing a layer of Sn to the plated Cu layer includes plating Cu on the patterned seed layer to form a patterned Cu layer matching the pattern of the pattered seed layer.

4. The method of claim 1, wherein introducing a layer of Sn to the plated Cu layer includes placing a leadframe with a layer of Sn thereupon onto the plated Cu.

5. The method of claim 1, wherein heating to react substantially all of the Sn to form a Cu-Sn intermetallic compound includes forming a Cu-Sn intermetallic compound that is substantially free of lead.

6. The method of claim 1, wherein heating to react substantially all of the Sn to form a Cu-Sn intermetallic compound includes forming Cu₆Sn₅.

7. The method of claim 1, wherein heating to react substantially all of the Sn to form a Cu-Sn intermetallic compound includes forming a Cu-Sn intermetallic compound having a melting point that is substantially higher than the melting point of the Cu-Sn alloy.

8. The method of claim 1, wherein sputtering a barrier layer-adhesion promoter on a connection surface includes sputtering at least one of titanium, aluminum, nickel and vanadium.

9. The method of claim 1, wherein sputtering an adhesion promoter on a connection surface includes sputtering a 0.2 µm layer of an adhesion promoter.

10. The method of claim 1, wherein applying a seed layer of Cu on the adhesion promoter includes applying a 0.2 µm layer of Cu.

11. The method of claim 1, wherein plating Cu on the seed layer to form a plated Cu layer includes plating a 5 µm layer of Cu.

12. The method of claim 1, further including forming the layer of Sn to a thickness of about 3 µm.

13. The method of claim 1, wherein
sputtering a barrier layer-adhesion promoter on a connection surface includes sputtering a 0.2 µm layer of the adhesion promoter,
applying a seed layer of Cu on the barrier layer-adhesion promoter includes applying a 0.2 µm layer of Cu,
plating Cu on the seed layer to form a plated Cu layer includes plating a 5 µm layer of Cu, and
forming a layer of Sn includes forming a 3 µm layer of Sn on the plated Cu layer.

14. The method of claim 1, wherein
forming a layer of Sn on the plated Cu layer to form a Cu-Sn alloy includes forming a Cu-Sn alloy having a melting point that is less than about 230°C, and
reacting substantially all of the Sn to form a Cu-Sn intermetallic compound includes forming a Cu-Sn intermetallic compound having a re-melting temperature of at least about 400°C.

15. The method of claim 1, further including applying a flux material to the Cu-Sn alloy, before heating the Cu-Sn alloy, to mitigate oxidation of the Cu-Sn alloy.

16. The method of claim 1, further including patterning the Cu-Sn alloy, prior to heating of the alloy and forming the Cu-Sn intermetallic compound.

17. A method for joining a semiconductor substrate with a leadframe having tin connectors, the method comprising:
sputtering a barrier layer-adhesion promoter on a surface of the substrate;
sputtering a seed layer of Cu on the barrier layer-adhesion promoter;
patterning the seed layer and adhesion promoter to form a bond pad pattern;
galvanically plating Cu on the patterned seed layer to form a patterned Cu layer having a pattern that matches the patterned seed layer;
positioning the leadframe to contact the tin connectors with the patterned Cu layer;
heating the Cu and Sn forming a Cu-Sn alloy, melting the alloy, and reacting substantially all of the Sn to form a Cu-Sn intermetallic compound that physically and electrically connects the substrate surface with the leadframe.

18. An integrated circuit package comprising:
an integrated circuit substrate having
a sputtered adhesion promoter on a bond connection surface of the substrate,
a seed layer of Cu on the adhesion promoter, and
plated Cu on the seed layer; and
a leadframe having a layer of Sn for bonding with the integrated circuit substrate via the plated Cu, the layer of Sn being configured via its thickness to
upon contact with the Cu and heating of the Cu and Sn, form a Cu-Sn alloy that melts, and
form a Cu-Sn intermetallic compound from the alloy via reaction of substantially all of the Sn, the compound physically and electrically connecting the connection surface with the leadframe.

19. The integrated circuit package of claim 18, wherein
the seed layer of Cu is a patterned layer,
the plated Cu has a pattern that matches the pattern of the seed layer, and
the layer of Sn on the leadframe is a patterned layer having a pattern that matches the pattern of the plated Cu.

20. The integrated circuit package of claim 18, wherein the layer of Sn is configured via its thickness to form the Cu-Sn intermetallic compound via consumption of substantially all of the Sn at a selected temperature that is at least about the melting point of the Cu-Sn alloy, the Cu-Sn intermetallic compound having a melting point that is substantially higher than the melting point of the Cu-Sn alloy.
